Europäisches Patentamt

European Patent Office

Office européen des brevets

(19)

(11) **EP 0 903 750 B1**

(12) **FASCICULE DE BREVET EUROPEEN**

(45) Date de publication et mention
de la délivrance du brevet:
**15.11.2000 Bulletin 2000/46**

(51) Int Cl.$^7$: **G11C 16/06**, H03K 4/94

(21) Numéro de dépôt: **98460036.1**

(22) Date de dépôt: **10.09.1998**

(54) **Procédé et circuit de génération de la tension de programmation et d'effacement dans une mémoire non volatile**

Verfahren und Schaltung zur Erzeugung der Programmier- und Löschspannung in einem nichtflüchtigen Speicher

Method and circuit for generating programming and erasing voltage in nonvolatile memory

(84) Etats contractants désignés:
**DE FR GB IT**

(30) Priorité: **19.09.1997 FR 9711912**

(43) Date de publication de la demande:
**24.03.1999 Bulletin 1999/12**

(73) Titulaire: **STMicroelectronics SA
94250 Gentilly Cedex (FR)**

(72) Inventeurs:
• **Naura, David
  56100 Lorient (FR)**
• **Zink, Sébastien
  56100 Lorient (FR)**

(74) Mandataire: **Ballot, Paul
Cabinet Ballot-Schmit,
4 Rue Général Hoche
56100 Lorient (FR)**

(56) Documents cités:
**EP-A- 0 762 428**

• **LUCERO ET AL: "A 16 kbit smart 5V-only
  EEPROM with redundancy" IEEE JOURNAL OF
  SOLID-STATE CIRCUITS., vol. 18, no. 5, octobre
  1983, pages 539-544, XP002066699 NEW YORK
  US**
• **LUBIN GEE ET AL: "An enhaced 16K E2PROM"
  IEEE JOURNAL OF SOLID-STATE CIRCUITS.,
  vol. 17, no. 5, octobre 1982, pages 828-832,
  XP002066751 NEW YORK US**
• **PATENT ABSTRACTS OF JAPAN vol. 7, no. 17
  (E-154) [1162], 22 janvier 1983 & JP 57 176826 A
  (HITACHI SEISAKUSHO), 30 octobre 1982**

**Description**

La présente invention concerne un procédé et un circuit de génération de la tension de programmation ou d'effacement d'une cellule mémoire non volatile. L'invention trouve son application dans le domaine des mémoires non volatiles, programmables et effaçables électriquement (EPROM, EEPROM, flash).

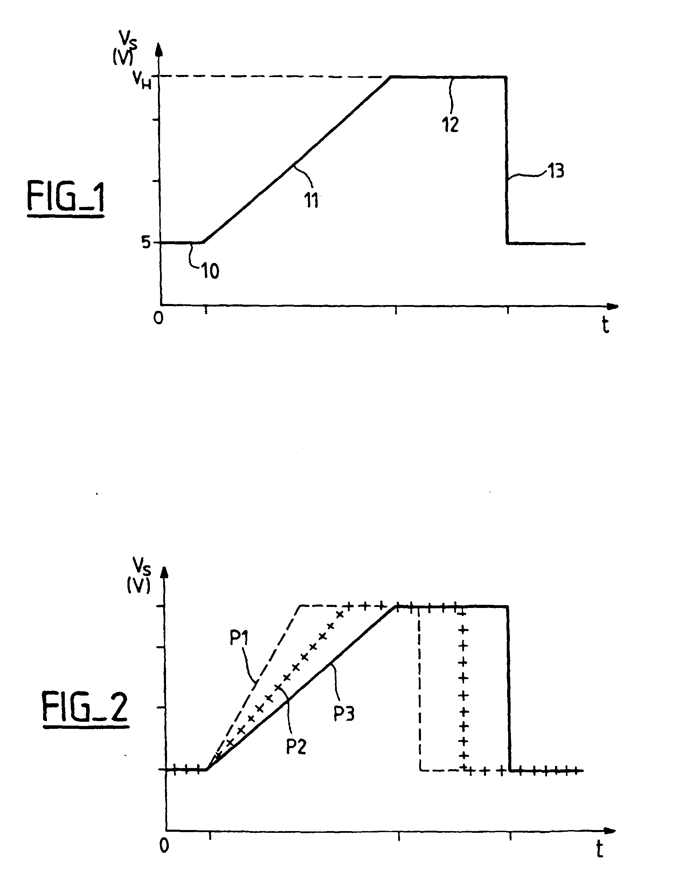

Les cellules mémoire de ces mémoires font appel à une technologie utilisant des transistors à grille flottante. Pour la programmation ou l'effacement d'une telle cellule mémoire, il est nécessaire de produire des hautes tensions de l'ordre de 15 à 20 volts. Ces tensions sont fournies soit par une source de tension externe, soit de manière interne par une pompe de charge intégrée dans la mémoire. La tension de programmation ou d'effacement appliquée sur une cellule mémoire est représentée à la figure 1. Elle comporte de manière classique

- une polarisation de départ à la tension d'alimentation Vcc de la mémoire constituant un premier plateau 10 en tension;
- une rampe de tension constituée d'une phase ascendante 11 pendant laquelle la tension grimpe de façon linéaire jusqu'à une haute tension $V_H$ et d'un plateau 12 en tension; et
- une chute de tension 13 pendant laquelle la tension revient à la valeur de la tension de départ.

La phase ascendante de la rampe de tension est caractérisée par sa pente, laquelle est soumise à deux conditions. Premièrement, elle ne doit pas être trop élevée de manière à ne pas stresser l'oxyde de grille de la cellule adressée. En effet, il est indispensable que, pendant la phase ascendante, la variation du champ électrique à l'intérieur de la cellule adressée ne soit pas trop brutale pour ne pas fragiliser voire détériorer l'oxyde de grille de la cellule. Deuxièmement, le temps de montée de la rampe de tension doit être calculé de manière à ce que la charge capacitive adressée dans la mémoire n'agisse pas sur la pente de la rampe. Il faut pour cela que la sortance S de la pompe de charge chargée de fournir la haute tension au circuit de génération de la rampe de tension soit supérieure à la charge capacitive adressée C multipliée par la pente de la rampe; c'est-à-dire il faut que:

$$S > C*dV/dt \qquad (1)$$

Si cette relation n'est pas vérifiée, la pente de la rampe n'est pas contrôlée et la tension appliquée sur la cellule mémoire à écrire n'est plus maîtrisée. La charge capacitive adressée varie en fonction du nombre de cellules mémoire écrites simultanément. La charge capacitive adressée est donc différente suivant que la mémoire fonctionne en mode normal (mode octet ou mode "byte"), en mode page ou en mode global.

Pour que la relation (1) soit toujours vérifiée, il existe deux méthodes possibles:

- soit on prévoit une pompe de charge ayant une sortance élevée;
- soit on choisit une rampe de tension dont la pente est suffisamment faible pour que la relation (1) soit toujours vérifiée quelle que soit la charge capacitive adressée.

Ces deux méthodes présentent cependant quelques inconvénients. En ce qui concerne la première méthode, il n'est pas toujours possible d'augmenter la sortance de la pompe de charge. En effet, la pompe de charge est classiquement une pompe de Schenkel dont la sortance est proportionnelle à $C_e*f/n$ et où $C_e$ désigne la capacité d'un étage de la pompe, f désigne la fréquence de pompage et n désigne le nombre d'étages de la pompe. Augmenter la sortance de la pompe oblige à diminuer le nombre d'étages n, ce qui n'est pas possible car n fixe la tension délivrée par la pompe, ou à augmenter $C_e$ ou f, ce qui est très coûteux en terme de place sur silicium. Sinon, la seconde méthode pénalise le temps d'écriture des cellules de la mémoire- et donc la rapidité de la mémoire. Elle pénalise en particulier le fonctionnement de la mémoire en mode normal par rapport à celui en mode page ou en mode global.

Un but de l'invention est de proposer un procédé de génération de la tension d'écriture dans une mémoire non volatile optimisant le temps d'écriture des cellules de la mémoire et un circuit mettant en oeuvre ce procédé. Selon l'invention, ce but est atteint et les inconvénients de l'art antérieur sont atténués ou supprimés en adaptant de manière dynamique la pente de la rampe à la charge capacitive adressée. Ainsi, les performances de la mémoire en matière de vitesse de programmation ou d'effacement s'adaptent aux besoins du client sans pour autant pénaliser la mémoire sur le plan de la surface sur silicium occupé par le circuit.

L'invention a donc pour objet un procédé de programmation ou d'effacement des cellules mémoire d'une mémoire non volatile comprenant les étapes suivantes :

- produire une tension de programmation ou d'effacement comportant un front montant de tension sous forme de rampe de pente P, et
- appliquer cette tension de programmation ou d'effacement sur les cellules mémoire à programmer ou à effacer,

caractérisé en ce que, lors d'une opération de programmation ou d'effacement dans la mémoire, on adapte la pente P de ladite rampe de tension en fonction du nombre de cellules mémoire à programmer ou à effacer simultanément lors de cette opération.

Ainsi, des valeurs de pente différentes sont associées aux trois modes de fonctionnement de la mémoire (mode normal, mode page et mode global).

Dans un mode de réalisation préféré, la valeur de la pente en mode page est comprise entre une valeur minimale et une valeur maximale. Elle est définie entre ces deux valeurs limite en fonction du nombre de cellules mémoire adressées en mode page, ce nombre étant déterminé pendant une étape d'acquisition précédant la génération de la tension de programmation ou d'effacement.

L'invention concerne également un circuit de programmation ou d'effacement des cellules mémoire d'une mémoire non volatile comportant

- un circuit de génération de tension d'écriture pour générer une tension de programmation ou d'effacement comprenant un front montant de tension sous forme de rampe de pente P, et
- des moyens de sélection pour appliquer ladite tension de programmation ou d'effacement sur les cellules mémoire à programmer ou à effacer,

caractérisé en ce que le circuit de génération de la tension d'écriture comporte des moyens pour faire varier la pente de la rampe de la tension de programmation ou d'effacement en fonction du nombre de cellules mémoire à programmer ou à effacer simultanément.

D'autres caractéristiques et avantages de l'invention apparaîtront à la lecture de la description détaillée qui suit et qui est faite en référence aux dessins annexés dans lesquels :

- la figure 1, déjà décrite, est un diagramme temporel de la tension de programmation (ou d'effacement) appliquée sur une ou plusieurs cellules mémoire;
- la figure 2 est un diagramme temporel des tensions de programmation (ou d'effacement) pour une mémoire fonctionnant selon trois modes;
- la figure 3 est un schéma fonctionnel d'un circuit de programmation ou d'effacement d'une mémoire non volatile selon l'invention; et
- la figure 4 est un mode de réalisation du circuit de génération de la tension d'écriture selon l'invention.

Selon l'invention, on prévoit de moduler lors d'une opération d'écriture la pente de la rampe de la tension d'écriture en fonction du nombre de cellules mémoire adressées simultanément.

Une valeur de pente est donc définie pour chaque mode d'écriture de la mémoire. Elle est inversement proportionnelle au nombre de cellules mémoire destinées à recevoir simultanément la tension d'écriture. La tension Vs pour les trois modes de fonctionnement de la mémoire est représentée à la figure 2. La partie ascendante de cette tension présente une pente de valeur P1 en mode normal, une pente de valeur P2 en mode page et une pente de valeur P3 en mode global avec P1 > P2 > P3.

La valeur P1 est calculée de manière à ce que, pour une sortance S donnée du circuit, la relation S > P1 ∗ C1 soit vérifiée, C1 représentant la charge capacitive de huit cellules mémoire en parallèle. La valeur P1 est -également majorée par une valeur limite, valeur à partir de laquelle le champ électrique est trop intense à l'intérieur de la cellule mémoire.

De manière identique, la valeur P2 vérifie la relation S > P2 ∗ C2 où C2 représente la charge capacitive d'une page. Généralement, la taille d'une page est égale à 8, 16, 32 ou 64 octets. Dans un premier mode de réalisation, la valeur P2 est indépendante de la taille de la page et est donc prise égale à la valeur correspondant à une page de taille maximale, c'est-à-dire 64 octets. Dans un mode de réalisation amélioré décrit plus loin, on détermine la taille de la page dans une première étape et on génère une pente P2 qui est fonction de cette taille.

Enfin, la valeur P3 est déterminée de la même façon en fonction de la charge capacitive C3 en mode global.

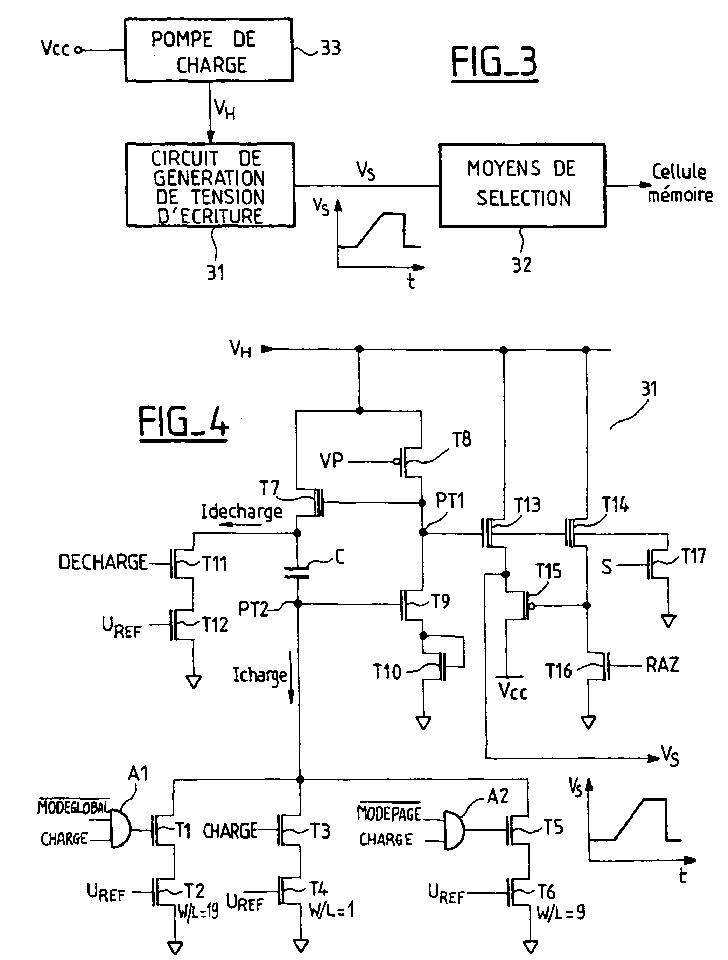

Selon l'invention, la variation de pente est obtenue en chargeant plus ou moins rapidement un condensateur. Un circuit mettant en oeuvre le procédé de l'invention est décrit aux figures 3 et 4. Il a pour but de produire une tension d'écriture Vs dont la pente de la rampe est fonction du mode de fonctionnement de la mémoire.

En référence à la figure 3, le circuit de l'invention est constitué d'un circuit de génération de tension d'écriture 31 qui délivre la tension d'écriture Vs, laquelle est appliquée sur la ou les cellules mémoire par l'intermédiaire de moyens de sélection 32 qui permettent de sélectionner les cellules mémoire à programmer ou à effacer. Le circuit 31 est alimenté avec une haute tension $V_H$ fournie par une pompe de charge 33.

Le circuit 31 est détaillé à la figure 4. Il comprend principalement:

- un condensateur C dont le temps de charge correspond au temps de montée de la tension Vs,
- un circuit de régulation du courant de charge du condensateur C,
- un circuit de charge fixant le courant de charge du condensateur C,
- un circuit de commande du circuit de charge pour adapter la valeur du courant de charge au nombre de cellules mémoire à programmer ou à effacer simultanément, et
- un circuit de décharge du condensateur C.

Pour obtenir une rampe de tension à la sortie du circuit, on vient charger le condensateur C avec un courant Icharge. La valeur de ce courant détermine le temps de charge du condensateur C et par là-même le temps de montée de la rampe de tension. Le courant de charge Icharge est fixé par un circuit de charge connecté à la borne inférieure du condensateur C.

Le courant de charge Icharge dépend du mode d'écriture employé. Les trois modes d'écriture possibles sont : le mode page, le mode global et le mode normal (mode byte). Le circuit de charge est composé de trois branches montées en parallèle entre la borne inférieure du condensateur C et la masse. Chaque branche est constituée de deux transistors MOS à canal N montés en série. En mode normal, les transistors des trois branches sont passants afin de fixer un courant de charge important tandis que pour les deux autres modes, seules deux des trois branches sont passantes.

La première branche est constituée de deux transistors T1 et T2. Le transistor T1 est commandé par un signal issu d'une porte logique A1 de type ET qui reçoit sur ses entrées des signaux CHARGE et MODEGLOBAL-. Le signal CHARGE est actif pendant la charge du condensateur C et le signal MODEGLOBAL- l'est quand la mémoire n'est pas en mode global. Le transistor T2 reçoit sur sa grille une tension de référence constante $U_{REF}$ et est utilisé comme source de courant constant.

La deuxième branche comporte deux transistors T3 et T4. Le transistor T3 est commandé par le signal CHARGE et le transistor T4 est commandé par la tension $U_{REF}$. Enfin, la troisième branche comprend deux transistors T5 et T6. Le transistor T5 est commandé par le signal issu d'une porte logique A2 de type ET qui reçoit sur ses entrées le signal CHARGE et un signal MODEPAGE-. Le signal MODEPAGE- est un signal logique actif quand la mémoire n'est pas en mode page. Le transistor T6 reçoit sur sa grille la tension $U_{REF}$ et est équivalent à une source de courant constant. La valeur du courant Icharge est déterminée par la taille des transistors T2, T4 et T6. Par ailleurs, les transistors T1, T2 et T3 fonctionnent en saturation et sont utilisés comme interrupteurs.

En mode normal, le courant de charge Icharge est égal à la somme des courants imposés par les transistors T2, T4 et T6. En mode page, le condensateur est chargé uniquement par le courant imposé par les transistors T2 et T4. Enfin, en mode global, le courant de charge est égal à la somme des courants imposés par les transistors T4 et T6.

La taille des transistors T2, T4 et T6 fixe la valeur des courants de charge des trois modes. Pour une page de X octets, la charge capacitive est X fois plus élevée qu'en mode normal; il en résulte que la taille du transistor T2 est (X-1) fois plus élevé que celle du transistor T4 si on désire que la valeur du courant de charge soit inversement proportionnelle à la charge capacitive adressée. Dans la pratique, cela n'est pas réalisé car le circuit serait beaucoup trop couteux en terme de silicium. C'est pourquoi, dans l'exemple de la figure 4, on choisit trois valeurs de courant de charge I1, I2, I3 respectivement pour le mode normal, le mode page et le mode global définies de la manière suivante: I1 = 10*I2 = 20*I3, et dont les pentes respectives P1, P2 et P3 vérifient la relation (1). Les rapports W/L des transistors du circuit de charge sont donc les suivants : W/L(T4)=1; W/L(T2)=19 et W/L(T6)=9. Dans cet exemple, on choisit de pénaliser le temps d'écriture en mode normal pour limiter la taille des transistors T2 et T6, cependant ce temps d'écriture reste bien plus faible que dans une mémoire classique. Il s'agit là de réaliser un compromis entre la taille du circuit (taille des transistors du circuit de charge) et le gain en vitesse d'écriture.

Le circuit 31 comporte par ailleurs un circuit de régulation du courant de charge alimenté par la tension $V_H$ correspondant à la valeur maximale de la tension Vs. Il comporte un transistor MOS à canal N, T7, dont le drain reçoit la tension $V_H$ et dont la source est connectée à la borne supérieure du condensateur C. Sa grille est par ailleurs connectée au drain d'un transistor MOS à canal P, T8. La tension $V_H$ est appliquée sur la source de ce dernier et une tension de polarisation VP légèrement inférieure à la tension $V_H$ est appliquée sur sa grille.

Le circuit de régulation du courant de charge comporte également un transistor T9 dont la grille est reliée à la borne inférieure du condensateur C, dont le drain est connecté au drain du transistor T8 et dont la source est reliée à la masse par l'intermédiaire d'un transistor T10 monté en diode. Le transistor T10 est utilisé ici comme résistance. La régulation du courant se fait de la manière suivante: si le courant de charge diminue, le potentiel sur la borne inférieure du condensateur C diminue et le transistor T9 devient plus résistant. Le potentiel sur la grille du transistor T7 augmente alors, le transistor T7 devient moins résistant et le courant de charge augmente.

Le circuit 31 comporte également un circuit de décharge connecté entre la borne supérieure du condensateur C et la masse. Ce circuit de décharge comprend deux transistors T11 et T12 montés en série. Le transistor est commandé par un signal DECHARGE actif pendant la phase de décharge du condensateur C. Le transistor T12 est commandé par la tension $U_{REF}$ et est dimensionné de manière à décharger très rapidement le condensateur C. La taille du transistor T12 fixe la valeur de ce courant de décharge.

Enfin, le circuit comporte un dispositif pour générer la tension de référence de la tension d'écriture représenté à la figure 1. Dans l'exemple de la figure 4, la tension de référence est égale à la tension d'alimentation Vcc de la mémoire. Ce dispositif comporte deux transistors MOS à canal N, T13 et T14, dont le drain est alimenté par la tension $V_H$ et dont la grille est connectée au drain du transistor T8 du circuit de régulation. La source du transistor T13 est connectée à la tension d'alimentation Vcc par l'intermédiaire d'un transistor MOS à canal P, T15. La grille du transistor T15 est reliée à la source du transistor T14. Ainsi lorsque la tension de grille des transistors T13 et T14 est faible, le transistor T15 est passant et impose la tension Vcc sur la source du transistor T13. Un transistor supplémentaire T16 à canal N est prévu pour annuler la tension Vs lorsque le circuit est désactivé (signal RAZ à l'état haut). La tension d'écriture Vs est prélevée sur la source du transistor T13. Enfin, le circuit est complété par un transistor T17 à canal N pour faire chuter la tension Vs (chute en tension 13 sur la figure 1) en fin d'opération. Ce transistor est commandé par un signal S actif pendant la phase 13 de la tension Vs.

Le circuit fonctionne de la manière suivante : pendant une phase de charge correspondant à la phase ascendante de la tension Vs, le condensateur C se charge et la tension à ses bornes augmente progressivement. La valeur du courant Icharge est plus ou moins élevée suivant l'état des signaux MODEPAGE- et MODEGLOBAL-. Dans la suite de la description, les potentiels PT1 et PT2 désignent respectivement le potentiel sur la grille du transistor T13 et le potentiel sur la borne inférieure du condensateur. A mesure que le potentiel de la borne supérieure du condensateur C augmente, le potentiel PT1 et la tension Vs augmentent. Il arrive un moment où le potentiel PT1 atteint un maximum. Le condensateur C continuant à se charger, le potentiel PT2 s'abaisse. Quand le potentiel PT2 devient alors inférieur à la valeur seuil du transistor T9, celui-ci se bloque. La charge est alors interrompue et la décharge du condensateur est amorcée. Pendant la phase de décharge, la tension Vs est maintenue à sa valeur maximale car le transistor T9 est bloqué. Pendant cette phase, la tension Vs présente un plateau en tension (référencé 12 sur la figure 1). Le potentiel sur la borne supérieure du condensateur chute au fur et à mesure que le condensateur se décharge et le signal DECHARGE est désactivé lorsque ce potentiel passe en dessous d'un potentiel seuil. A ce moment précis, le signal S devient actif, le transistor T17 devient passant et la tension Vs chute (phase 13 sur la figure 1) jusqu'à la valeur de référence Vcc imposé par le transistor T15.

Ce circuit a été conçu pour produire une tension d'écriture Vs particulière pour chaque mode d'écriture de la mémoire.

Dans un mode de réalisation amélioré, on peut envisager d'affiner la pente de la tension Vs en mode page en tenant compte du nombre exact de cellules mémoire adressées par page. Pour se faire, il suffit de faire un comptage des cellules mémoire adressées en mode page avant de générer la tension Vs et d'associer à la valeur obtenue une valeur de courant de charge particulière. En pratique, on compte le nombre d'impulsions Nh d'horloge nécessaires pour charger la page dans les circuits tampons de la mémoire avant la programmation de la page dans les cellules de la mémoire et on adapte le courant de charge en mode page à ce nombre. Il suffit par exemple d'un compteur 6 bits (comptage jusqu'à 64) pour acquérir le nombre Nh et de quatre transistors identiques montés en parallèle à la place du transistor T2 imposant chacun un courant de charge I. A la suite de l'étape de comptage ou phase d'acquisition, on active :

- quatre transistors si Nh < 8,
- trois transistors si $8 \leq Nh < 16$,
- deux transistors si $16 < Nh < 32$, et
- un transistor si $Nh \geq 32$.

Le courant de charge est alors fonction du nombre d'octets compris dans une page.

## Revendications

1. Procédé de programmation ou d'effacement des cellules mémoire d'une mémoire non volatile comprenant les étapes suivantes :

   - produire une tension de programmation ou d'effacement (Vs) comportant un front montant de tension sous forme de rampe (11) de pente P, et
   - appliquer cette tension de programmation ou d'effacement (Vs) sur les cellules mémoire à programmer ou à effacer,

   caractérisé en ce que, lors d'une opération de programmation ou d'effacement dans la mémoire, on adapte la pente P de ladite rampe de tension en fonction du nombre de cellules mémoire à programmer ou à effacer simultanément lors de cette opération.

2. Procédé selon la revendication 1, caractérisé en ce qu'on associe à la pente de la rampe de tension une première valeur (P1) lorsqu'un groupe de n cellules mémoire est à programmer ou à effacer simultanément, une seconde valeur (P2) lorsqu'une pluralité de groupes de n cellules mémoire est à programmer ou à effacer simultanément, et une troisième valeur (P3) lorsque la totalité des cellules de la mémoire ou d'un secteur de la mémoire est à programmer ou à effacer simultanément.

3. Procédé selon la revendication 2, caractérisé en ce que la pente de la rampe de tension est proportionnelle au temps de charge d'un condensateur et en ce que les trois valeurs de pente (P1, P2, P3) de la rampe de tension sont associées à trois valeurs de courant de charge dudit condensateur.

4. Procédé selon la revendication 2, caractérisé en ce que la seconde valeur (P2) est comprise entre une valeur limite minimale et une valeur limite maximale, et est définie entre ces valeurs limite en fonction du nombre de groupe de n cellules mémoire à programmer ou effacer simultanément.

5. Circuit de programmation ou d'effacement des cellules mémoire d'une mémoire non volatile comportant

- un circuit de génération de tension d'écriture (31) pour générer une tension de programmation ou d'effacement (Vs) comprenant un front montant de tension sous forme de rampe (11) de pente P, et
- des moyens de sélection (32) pour appliquer ladite tension de programmation ou d'effacement sur les cellules mémoire à programmer ou à effacer,

caractérisé en ce que le circuit de génération de la tension d'écriture comporte des moyens pour adapter la pente de la rampe de la tension de programmation ou d'effacement en fonction du nombre de cellules mémoire à programmer ou à effacer simultanément.

6. Circuit selon la revendication 5, caractérisé en ce que le circuit de génération de la tension d'écriture (31) comporte :

- un condensateur (C) dont le temps de charge est proportionnel à la pente de la rampe de tension,
- un circuit de charge pour imposer un courant de charge dudit condensateur, et
- un circuit de commande du circuit de charge pour adapter la valeur du courant de charge au nombre de cellules mémoire à programmer ou à effacer simultanément.

7. Circuit selon la revendication 6, caractérisé en ce que le circuit de charge comporte une pluralité de transistors montés en parallèle et répartis en trois groupes, et

en ce qu'il impose une première valeur de courant de charge lorsque les transistors des trois groupes sont passants, une seconde valeur de courant de charge lorsque les transistors des premier et second groupes sont passants, et une troisième valeur de courant de charge lorsque les transistors des second et troisième groupes sont passants.

**Claims**

1. Method of programming or erasing memory cells in a nonvolatile memory comprising the following steps:

- producing a programming or erasing voltage (Vs) having a voltage rising edge in the form of a ramp (11) with a slope P, and

- applying this programming or erasing voltage (Vs) to the memory cells to be programmed or erased,

characterised in that, during an operation or programming or erasing in the memory, the slope P of the said voltage ramp is adapted according to the number of memory cells to be programmed or erased simultaneously during this operation.

2. Method according to Claim 1, characterised in that a first value (P1) is associated with the slope of the voltage ramp when a group of n memory cells is to be programmed or erased simultaneously, a second value (P2) when a plurality of groups of n memory cells are to be programmed or erased simultaneously, and a third value (P3) when all the cells in the memory or a sector of the memory are to be programmed or erased simultaneously.

3. Method according to Claim 2, characterised in that the slope of the voltage ramp is proportional to the time taken for charging a capacitor and in that the three slope values (P1, P2, P3) of the voltage ramp are associated with three values of the current for charging the said capacitor.

4. Method according to Claim 2, characterised in that the second value (P2) lies between a minimum limit value and a maximum limit value, and is defined between these limit values according to the number of groups of n memory cells to be programmed or erased simultaneously.

5. Circuit for programming or erasing memory cells in a nonvolatile memory having

- a write voltage generating circuit (31) for generating a programming or erasing voltage (Vs) comprising a voltage rising edge in the form of a ramp (11) with a slope P, and

- selection means (32) for applying the said programming or erasing voltage to the memory cells to be programmed or erased,

characterised in that the write voltage generating circuit has means for adapting the slope of the ramp of the programming or erasing voltage according to the number of memory cells to be programmed or erased simultaneously.

6. Circuit according to Claim 5, characterised in that the write voltage generating circuit (31) has:

- a capacitor (C) whose charging time is proportional to the slope of the voltage ramp,

- a charging circuit for imposing a current for charging the said capacitor, and

- a circuit for controlling the charging circuit for adapting the value of the charging current to the number of memory cells to be programmed or erased simultaneously.

7. Circuit according to Claim 6, characterised in that the charging circuit has a plurality of transistors connected in parallel and distributed in three groups, and

in that it imposes a first charging current value when the transistors in the three groups are on, a second charging current value when the transistors in the first and second groups are on, and a third charging current value when the transistors in the second and third groups are on.

**Patentansprüche**

1. Verfahren zum Programmieren oder Löschen von Speicherzellen eines nichtflüchtigen Speichers mit den folgenden Schritten:

   - Erzeugen einer Programmier- oder Lösch-Spannung (Vs) mit einer Anstiegsflanke der Spannung in Form einer Rampe (11) mit der Steigung P und
   - Anlegen dieser Programmier- oder Lösch-Spannung (Vs) an die zu programmierenden oder zu löschenden Speicherzellen,

   dadurch gekennzeichnet, daß
   bei einer Programmier- oder Lösch-Operation in dem Speicher die Steigung P der Spannungsrampe in Abhängigkeit von der Zahl der gleichzeitig bei dieser Operation zu programmierenden oder zu löschenden Speicherzellen abhängt.

2. Verfahren nach Anspruch 1, dadurch gekennzeichnet, daß die Steigung der Spannungsrampe einen ersten Wert (P1) annimmt, wenn eine Gruppe mit n Speicherzellen simultan zu programmieren oder zu löschen ist, einen zweiten Wert (P2), wenn mehrere Gruppen mit n Speicherzellen gleichzeitig zu programmieren oder zu löschen sind, und einen dritten Wert (P3), wenn die Gesamtheit der Zellen des Speichers oder eines Sektors des Speichers gleichzeitig zu programmieren oder zu löschen sind.

3. Verfahren nach Anspruch 2, dadurch gekennzeichnet, daß die Steigung der Spannungsrampe proportional zur Ladezeit eines Kondensators ist und daß die drei Steigungswerte (P1, P2, P3) der Spannungsrampe drei Werten des Ladestroms des Kondensators entsprechen.

4. Verfahren nach Anspruch 2, dadurch gekennzeichnet, daß der zweite Wert (P2) zwischen einem minimalen Grenzwert und einem maximalen Grenzwert liegt und zwischen diesen Grenzwerten in Abhängigkeit von der Zahl der Gruppen von n Speicherzellen definiert ist, die gleichzeitig zu programmieren oder zu löschen sind.

5. Schaltkreis zum Programmieren oder Löschen von Speicherzellen eines nichtflüchtigen Speichers mit:

   - einem Schreibspannungsgeneratorschaltkreis (31) zum Erzeugen einer Programmier- oder Lösch-Spannung (Vs) mit einer Anstiegsflanke der Spannung in Form einer Rampe (11) mit der Steigung P, und
   - Auswahlmitteln (32) zum Anlegen der Programmier- oder Lösch-Spannung an die zu programmierenden oder zu löschenden Speicherzellen,

   dadurch gekennzeichnet, daß
   der Schreibspannungsgeneratorschaltkreis Mittel umfaßt, um die Steigung der Spannungsrampe für das Programmieren oder Löschen in Abhängigkeit von der Zahl der gleichzeitig zu programmierenden oder zu löschenden Speicherzellen festzulegen.

6. Schaltkreis nach Anspruch 5, dadurch gekennzeichnet, daß der Schreibspannungsgeneratorschaltkreis (31) umfaßt:

   - einen Kondensator (C), dessen Ladezeit proportional zur Steigung der Spannungsrampe ist,
   - einen Ladeschaltkreis zum Einstellen eines Ladestromes des Kondensators und
   - einen Steuerschaltkreis für den Ladeschaltkreis zum Anpassen des Wertes des Ladestroms an die Zahl der Speicherzellen, die gleichzeitig programmiert oder gelöscht werden sollen.

7. Schaltkreis nach Anspruch 6, dadurch gekennzeichnet, daß der Ladeschaltkreis mehrere Transistoren umfaßt, die parallel geschaltet und in drei Gruppen aufgeteilt sind, und daß er einen ersten Wert für den Ladestrom einstellt, wenn die Transistoren der drei Gruppen leitend sind, einen zweiten Wert für den Ladestrom, wenn die Transistoren der ersten und zweiten Gruppe leitend sind, und einen dritten Wert für den Ladestrom, wenn die Transistoren der zweiten und dritten Gruppe leitend sind.

FIG_1

FIG_2

FIG_3

FIG_4